Europäisches Patentamt

European Patent Office

Office européen des brevets

(19)

(11) Publication number: **0 085 211**

**A1**

(12)

# EUROPEAN PATENT APPLICATION

(21) Application number: **82300519.4**

(22) Date of filing: **01.02.82**

(51) Int. Cl.³: **H 01 M 2/10**

(43) Date of publication of application:
**10.08.83 Bulletin 83/32**

(84) Designated Contracting States:
**AT BE CH DE FR GB IT LI NL SE**

(71) Applicant: **COSE TECHNOLOGY CORPORATION**
**15 East 40th Street**
**New York New York 10019(US)**

(72) Inventor: **Cohen, Eric**
**15 East 40th Street**
**New York New York 10019(US)**

(72) Inventor: **Korwin, Paul**
**150-09 77th Avenue**
**Flushing New York 11367(US)**

(74) Representative: **Pritchard, Colin Hubert et al,**
**Mathys & Squire 10 Fleet Street**
**London EC4Y 1AY(GB)**

(54) **Improvements in telephone intruder alert systems.**

(57) A pair of cantilevered battery-holding retainers (22, 22) resiliently support a battery in a telephone handset-mounted, battery-powered, multi-component intruder alert system. Electrical wires for connecting system components mounted above a conventional telephone-type transmitter to microphone output terminals located at the underside of the transmitter, are routed through a bypass groove (84) extending through the transmitter. A retaining ring (86) retains and confines the wires within the groove.

FIG. 1

EP 0 085 211 A1

# IMPROVEMENTS IN TELEPHONE INTRUDER ALERT SYSTEMS

The present invention generally relates to telephone intruder alert systems.

A type of telephone intruder alert system is described and shown in United Kingdom pending patent application Ser. No. 79/05924, filed February 20, 1979, the entire contents of which being incorporated herein by reference. This known telephone intruder alert system includes a conventional telephone type transmitter microphone having an upper side, and a pair of output terminals at its lower side. A printed circuit board is mounted above the upper side, and a plurality of system components are mounted on the board. An elongated battery for supplying power to the system components, is rigidly mounted on the board by battery-holding retainers.

Electrical wires connect the system components, located on the board above the microphone, to the microphone output terminals located on the underside of the microphone. The wires are routed exteriorly of the microphone through a bypass groove machined in the inner surface of a mouthpiece cap which is threaded on the handset.

Although generally satisfactory for their intended purpose, the known battery-holding retainers support the battery too rigidly on the board. The rigid retainers do not provide or insure permanent contact with the battery ends, because of variation of battery length or permanent deflection of the retainers due to impact of the heavy battery during shipment or use of the device. In addition, the rigid retainers are spaced apart to very tightly clamp the battery therebetween, thereby making battery insertion and removal difficult. The use of an offset tongue on the retainers to electro-mechanically engage the opposite ends of the battery has not proven entirely practical. In the case of a tongue made of a relatively non-springy material, the relatively heavy battery sometimes deflects and permanently deforms the tongue either when the battery is inserted, or when the battery shifts during shipping. In the case of a tongue made of a flexible material, electrical contact between the flexible tongues and the battery ends is sometimes broken.

As for the routing of the electrical wires around the microphone, the loose wires in the space between the cap and the microphone, were sometimes compressed and damaged. Routing of wires through a bypass groove in the cap made production of the cap difficult and expensive. The unconfined orientation of the wires caused the board to move relative to the transmitter, and made assembly of the device and battery replacement difficult.

According to the present invention there is provided a cantilevered battery-holding arrangement for a telephone handset-mounted, battery-powered, intruder alert system of the type including a circuit board and a battery mounted on the circuit board and elongated along a longitudinal axis, the said arrangement being characterized by a pair of battery-holding retainers spaced longitudinally apart of each other on the board for snugly receiving the battery therebetween, each retainer being generally U-shaped and having a pair of generally parallel, longitudinally-extending planar side walls at opposite lateral sides of the battery, and a transversely-extending planar base wall extending between the side walls and across the respective end of the battery, each base wall being integrally connected with its associated side walls at respective corner regions at opposite lateral sides of the longitudinal axis, each base wall having an offset tongue extending outwardly of the plane of the base wall and towards a respective battery end for electro-mechanically engaging the same, and anchoring means on each retainer for mounting the same in cantilevered relationship of the board, the anchoring means of one retainer being located in the vicinity of one corner region thereof at one side of the longitudinal axis, the anchoring means of the other retainer being located in the vicinity of the opposite corner region thereof at the opposite side of the longitudinal axis, whereby the cantilevered retainers resiliently support the battery on the board.

In a preferred embodiment of this invention the battery is resiliently mounted on the board by cantilevered battery-holding retainers. Each U-shaped retainer has one side wall connected to a base wall at one corner region, and another side wall connected to the base wall at another corner region. Each retainer is anchored to the board in the vicinity of one of its corner regions. The cantilevered mounting of each retainer provides sufficient resilience to prevent the retainer, and any part thereof, from being excessively deflected and permanently deformed, but is flexible enough to prevent the retainer, and any part thereof, from breaking electro-mechanical contact with the battery ends.

According to the invention there is also provided a telephone handset-mounted, multi-component, intruder alert system of the type including a telephone-type transmitter having a pair of output terminals at one side thereof, a circuit board located at the other side of the transmitter, a plurality of components mounted on the board, and electrical wires connecting the components to the output terminals, a novel wire-bypass arrangement, characterized by a groove formed at the periphery of the transmitter and extending through the same from said one side to said other side thereof, said groove being dimensioned to accommodate the electrical wires routed through the groove, and a retainer ring mounted about the periphery of the transmitter and bounding the groove, so as to retain and confine the electrical wires within the groove.

In a preferred embodiment of the invention, the electrical wires are not routed around, but instead are routed through, the microphone. A shallow groove is formed at the periphery of the microphone without interfering with the internals of the microphone. A retainer ring is mounted about the microphone so as to bound the groove to thereby retain and confine the electrical wires therein. Hence, the wires are protected from damage; the cap need not be specially machined; and the retention of the wires in the groove stabilizes the position of the board to thereby facilitate battery replacement.

The invention will now be described, by way of example, with reference to the accompanying drawings, in which:-

FIG. 1 is a partially exploded, front perspective view of the cantilevered battery-holding and wire-bypass arrangements in accordance with this invention; and

FIG. 2 is a partially sectioned view of a detail of FIG. 1.

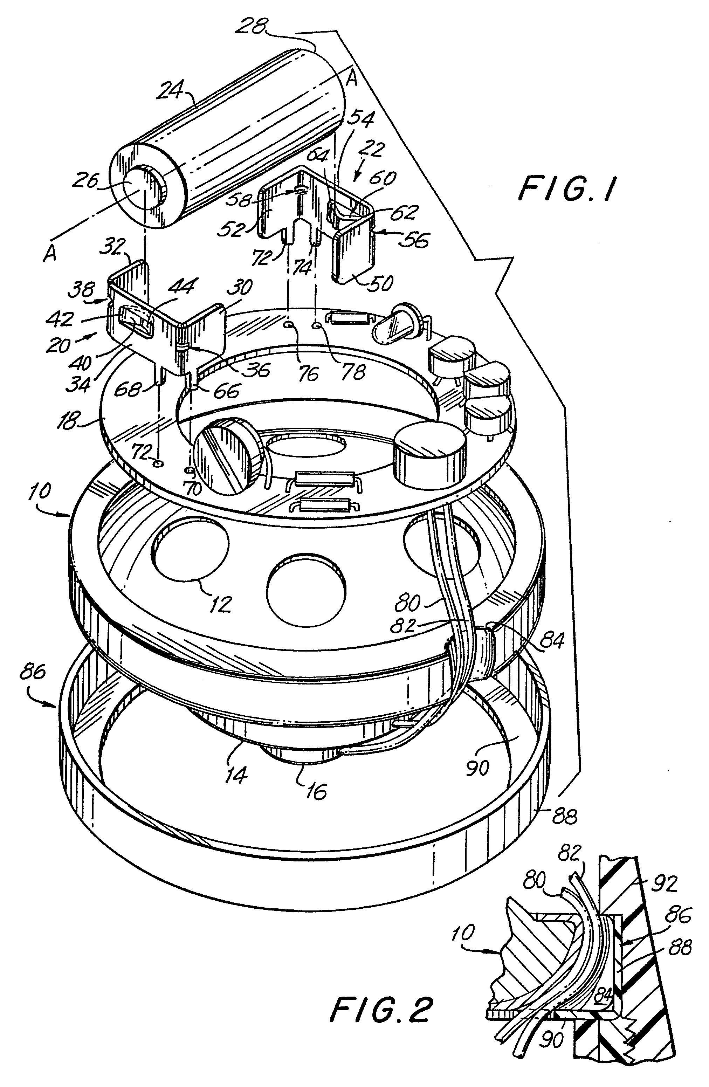

Referring now the FIG. 1, reference numeral 10 generally identifies a conventional telephone-type transmitter microphone having an upper side formed with sound holes 12, and a lower side with a pair of microphone output terminals 14, 16. An annular printed circuit board 18 is mounted above the microphone, and a plurality of telephone intruder alert system components are mounted on the board. The structure and operation of the system components have been described in the aforementioned United Kingdom application, the entire content of which is made part of this disclosure.

A pair of generally U-shaped, electrically conductive, battery-holding retainers 20, 22 are mounted on the board 18, and are spaced longitudinally apart of each other for snugly receiving an elongated battery 24 having an anode end 26 and a cathode end 28 therebetween. The battery 24 is elongated along a longitudinal axis A--A.

Retainer 20 has a pair of generally parallel, longitudinally-extending, planar side walls 30, 32 at opposite lateral sides of the battery, and a transversely-extending planar base wall 34 extending between the side walls and across the anode 26. Side walls 30, 32 are integrally connected with the base wall 34 at respective corner regions 36, 38 which are located at opposite sides of the longitudinal axis. An offset tongue 40 is stamped out of the base wall 34, and has a base portion 42 integrally connected with the base wall 34, and a free end portion 44 located out of the plane of the base wall. The free end portion 44 is located on the longitudinal axis and electro-mechanically engages the anode 26. Analogously, retainer 22 has a similar pair of side walls 50, 52; a base wall 54; a pair of corner regions 56, 58; and an offset tongue 50 having a base portion 62 and a free end portion 64 which engages cathode 28.

In accordance with the invention, anchoring means are provided on each retainer for mounting the same in cantilevered relationship to the board. The anchoring means on retainer 20 includes a first planar support leg 66 integrally connected with, and lying in the same plane as, side wall 30; and a second planar support leg 68 integrally connected with, and lying in the same plane as, the base wall 34. The legs 66, 68 are both located in the vicinity of corner region 36, which includes a bend line where the side wall 30 meets the base wall 34. Leg 66 is located a predetermined linear distance from this bend line, whereas leg 68 is located a greater distance from this bend line. Legs 66, 68 are at right angles to each other, extend through the holes 70, 72 in the board 18, and are secured thereto at the underside of the board by soldering or the like. Legs 66, 68 anchor the retainer 20 only at corner region 36, thereby permitting the portion of the base wall extending from leg 68 to corner region 38, as well as the entire side wall 32, to swing in cantilevered relationship, and to cause the free end portion 44 of the tongue 40 to resiliently and yieldingly bear against the anode 26.

Analogously, the anchoring means on the retainer 22 includes a first planar support leg 72 mounted on side wall 52, and a second planar support leg 74 on base wall 74. Legs 72, 74 are both mounted in the vicinity of corner region 58 which includes a bend line where side wall 52 meets base wall 54. Leg 74 is spaced further from this bend line than leg 72. Legs 72, 74 are situated at right angles to each other, extend through board holes 76, 78, and anchor the retainer 22 only at corner region 58, thereby permitting the portion of the base wall 54 extending from leg 74 to corner region 56, as well as the entire side wall 50, to swing in cantilevered relationship, and to cause the free end portion 64 of the tongue 60 to resiliently and yieldingly bear against the cathode 28.

The anchoring means 66, 68 on retainer 20 are located at one side of the longitudinal axis A--A, whereas the anchoring means 72,74 on retainer 22 are located at the opposite side of this axis. Hence, the battery is reliably and resiliently supported on the board 18.

In a preferred embodiment, each side wall is 1/4" long x .280" high; each base wall is 1/2" long; the wall thickness is about 0.02"; the legs on the side walls are spaced about 1/16" from their respective bend lines; the legs on the base walls are spaced about 0.15" from their respective bend lines; each leg is tapered from about 0.050" to about 0.034"; each leg extends downwardly about 0.115"; and the preferred material for the retainers is bright-tinned phosphor bronze.

In accordance with another feature, a pair of electrical wires 80, 82 extend from the system components on the board 18 above the microphone 10 to the output terminals 14, 16 at the underside of the microphone. A bypass groove 84 is formed, e.g., by grinding, at the periphery of the microphone and within the wall thickness thereof, and extends through the same without disturbing the carbon granules therein. The groove 84 is dimensioned to accommodate the wires 80, 82 routed therethrough with a slight clearance. A retaining ring 86 having an annular vertical flange 88 and an annular horizontal rim 90 is mounted about the periphery of the microphone. The flange 88 bounds the groove 84 at its open side so as to retain and confine the wires within the groove. No special groove need be machined in the telephone cap 92 within which the entire system is mounted. In a preferred embodiment, the bypass groove 84 is about 0.04" deep and 1/8" wide.

CLAIMS:

1.      A cantilevered battery-holding arrangement for a telephone handset-mounted, battery-powered, intruder alert system of the type including a circuit board and a battery mounted on the circuit board and elongated along a longitudinal axis, the said arrangement being characterized by:

        a.    a pair of battery-holding retainers spaced longitudinally apart of each other on the board for snugly receiving the battery therebetween,

        each retainer being generally U-shaped and having a pair of generally parallel, longitudinally-extending planar side walls at opposite lateral sides of the battery, and a transversely-extending planar base wall extending between the side walls and across the respective end of the battery,

        each base wall being integrally connected with its associated side walls at respective corner regions at opposite lateral sides of the longitudinal axis,

        each base wall having an offset tongue extending outwardly of the plane of the base wall and towards a respective battery end for electro-mechanically engaging the same; and

        b.    anchoring means on each retainer for mounting the same in cantilevered relationship of the board, the anchoring means of one retainer being located in the vicinity of one corner region thereof at one side of the longitudinal axis, the anchoring means of the other retainer being located in the vicinity of the opposite corner region thereof at the opposite side of the longitudinal axis, whereby the cantilevered retainers resiliently support the battery on the board.

2.      A cantilevered battery-holding arrangement as claimed in claim 1, wherein each anchoring means includes a first planar support leg integrally connected with, and lying in the same plane as, one of the side walls, and a second planar support leg integrally connected with, and lying in the same plane as, the base wall.

3.      A cantilevered battery-holding arrangement as claimed in · claim 2, wherein said one side wall is connected to the base wall at a bend line, and wherein said first leg is spaced at a predetermined distance from the bend line, and wherein said second leg is spaced at a distance from the bend line which is greater than said predetermined distance.

4.      A cantilevered battery-holding arrangement as claimed in any one of the preceding claims, wherein each offset tongue has a free end portion located on the longitudinal axis, and a base portion integrally connected with the base wall and located at the corner region opposite to that at which the anchoring means on the respective retainer is located.

5.      A telephone handset-mounted, battery-powered, intruder alert system including a circuit board and a battery mounted on the circuit board by means of a cantilevered battery-holding arrangement as claimed in any one of claims 1 to 4.

6.      A telephone handset-mounted, multi-component, intruder alert system of the type including a telephone-type transmitter having a pair of output terminals at one side thereof, a circuit board located at the other side of the transmitter, a plurality of components mounted on the board, and electrical wires connecting the components to the output terminals, a novel wire-bypass arrangement, characterized by:

a.      a groove formed at the periphery of the transmitter and extending through the same from said one side to said other side thereof, said groove being dimensioned to accommodate the electrical wires routed through the groove; and

b.      a retainer ring mounted about the periphery of the transmitter and bounding the groove, so as to retain and confine the electrical wires within the groove.

FIG.1

FIG.2

0085211

European Patent Office

**EUROPEAN SEARCH REPORT**

Application number

EP 82 30 0519

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| Y | DE-A-2 710 260 (NEUBERGER MESSINSTRUMENTE) *Page 6, 6th paragraph; figure 1* | 1 | H 01 M 2/10 |
| Y | GB-A-2 039 687 (GENERAL ELECTRIC COMPANY) *Page 1, lines 114-116; figure 1* | 1 | |
| A | US-A-2 692 944 (H.MENDELSON) *Column 2, lines 52-55; figure 1* | 1 | |
| A | US-A-2 983 778 (ROBERT A.MUNSE) *Column 1, lines 35-56; figure 1* | 1 | |

TECHNICAL FIELDS SEARCHED (Int. Cl. 3)

H 01 M 2/10
H 01 M 2/02
H 01 R
H 01 H

The present search report has been drawn up for all claims

| Place of search | Date of completion of the search | Examiner |
|---|---|---|
| THE HAGUE | 14-09-1982 | STANGE R.L.H |